(19) Europäisches Patentamt
European Patent Office
Office européen des brevets

(11) **EP 0 902 437 B1**

(12) **FASCICULE DE BREVET EUROPEEN**

(45) Date de publication et mention
de la délivrance du brevet:
**28.03.2007 Bulletin 2007/13**

(51) Int Cl.:
**G11C 16/06** *(2006.01)*    **H03K 17/16** *(2006.01)*

(21) Numéro de dépôt: **98402184.0**

(22) Date de dépôt: **03.09.1998**

(54) **Circuit de génération d'une haute tension de programmation ou d'effacement d'un mémoire**

Hochspannungsgeneratorschaltung zum Programmieren oder Löschen eines Speichers

High-voltage generating circuit for programming or erasing a memory

(84) Etats contractants désignés:
**DE FR GB IT**

(30) Priorité: **10.09.1997 FR 9711218**

(43) Date de publication de la demande:
**17.03.1999 Bulletin 1999/11**

(73) Titulaire: **STMicroelectronics S.A.**
**92120 Montrouge (FR)**

(72) Inventeur: **Ravazzini, Roberto**
**75116 Paris (JP)**

(74) Mandataire: **Ballot, Paul Denis Jacques et al**
**Cabinet Ballot**
**122, rue Edouard Vaillant**
**92593 Levallois-Perret Cedex (FR)**

(56) Documents cités:
**US-A- 4 488 060**

• **CARNEY B ET AL: "CONFIGURABLE EEPROMS FOR ASICS" PROCEEDINGS OF THE CUSTOM INTEGRATED CIRCUITS CONFERENCE, NEW YORK, MAY 16 - 19, 1988, no. CONF. 10, 16 mai 1988, pages 4.2.1-4.2.4, XP000043914 INSTITUTE OF ELECTRICAL AND ELECTRICAL ENGINEERS**
• **LUCERO ET AL: "A 16 kbit smart 5V-only EEPROM with redundancy" IEEE JOURNAL OF SOLID-STATE CIRCUITS., vol. 18, no. 5, octobre 1983, pages 539-544, XP002066699 NEW YORK US**

## Description

L'invention concerne un circuit de génération d'une haute tension en rampe pour l'alimentation d'une charge, notamment une haute tension de programmation ou d'effacement d'au moins une cellule mémoire. Elle s'applique tout particulièrement aux mémoires non volatiles, programmables et/ou effaçables électriquement (EPROM, EEPROM, mémoire Flash).

Les cellules mémoire de ces mémoires sont réalisées selon une technologie utilisant des transistors à grille flottante comme élément de mémorisation.

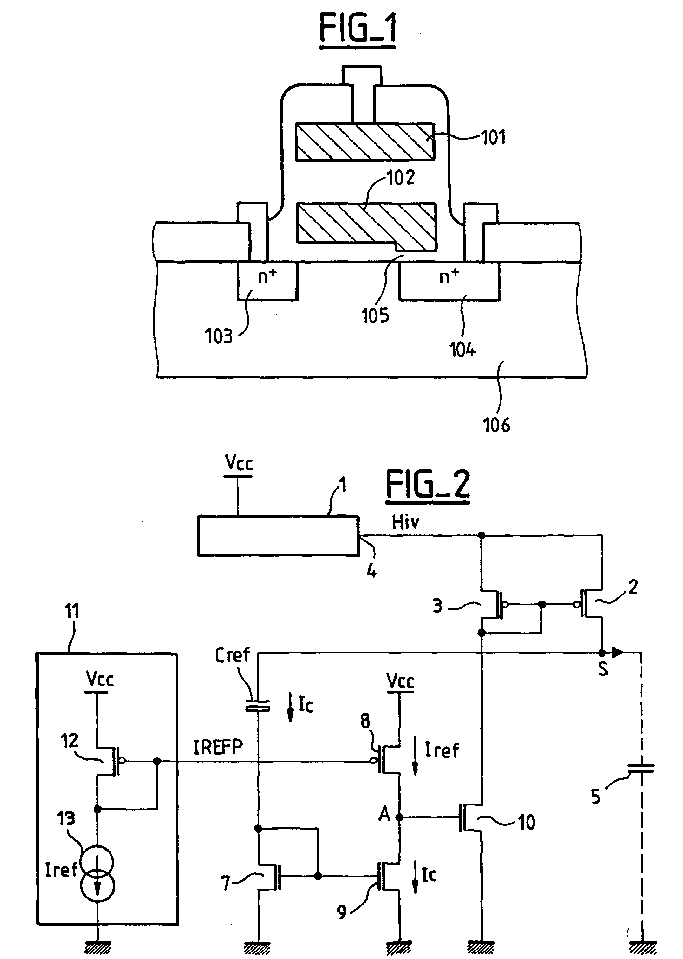

Ainsi, par exemple, une cellule mémoire d'une mémoire EEPROM est constituée d'un transistor à grille flottante (figure 1) comportant une grille de commande 101, une grille flottante 102, une région source 103, une région drain 104, une couche d'oxyde 105 et une région substrat 106. La grille 102 est dite flottante car elle ne possède aucun contact avec l'extérieur lui imposant un potentiel. La grille de commande 101 est reliée à une ligne de mot de la mémoire et la région drain 104 à une ligne de bit de la mémoire. La structure représentée à la figure 1 montre que l'épaisseur d'oxyde 105 entre la grille flottante 102 et la région substrat 106 est très réduite. Typiquement, elle est de l'ordre de quelques nanomètres. La faible épaisseur d'oxyde permet à cet endroit le passage d'électrons par effet tunnel.

Pour la programmation ou l'effacement d'une telle cellule mémoire, il est nécessaire de produire des hautes tensions de l'ordre de 15 à 20 volts. Les termes haute tension ou forte tension sont utilisés dans la suite pour désigner une tension élevée, de l'ordre de 15 à 20 volts, par rapport à la tension d'alimentations générale du circuit, qui est de l'ordre de 3 à 5 volts et qui peut même être inférieure, par exemple égale à 1,8 volts.

Pour programmer une cellule mémoire, on applique à la ligne de mot de la mémoire, reliée à la grille de commande 101 de la cellule mémoire, une forte tension positive et à la ligne de bit, reliée à la région drain 104, une tension nulle. L'application de ces tensions crée, à travers l'étroite couche d'oxyde 105, un champs électrique élevé ayant pour résultat la migration d'électrons vers la grille flottante 102 par effet tunnel. Ces électrons sont alors piégés dans la grille flottante 102.

A l'inverse, pour effacer une cellule mémoire, on applique à la ligne de bit une forte tension positive et à la ligne de mot une tension nulle. La migration des électrons se fait alors dans le sens inverse et la grille flottante 102 se décharge. Ainsi, la haute tension de programmation ou d'effacement est transmise sur une entrée de programmation du plan mémoire qui se comporte comme une charge de nature essentiellement capacitive du fait des capacités parasites des transistors à grille flottante qui le compose.

La haute tension de programmation ou d'effacement peut être produite par des moyens d'alimentation externes au circuit intégré incorporant la mémoire. Cependant, quand le circuit intégré pour lequel une haute tension de programmation doit être produite est un circuit autonome, notamment quand il s'agit d'une puce d'une carte à puce, la haute tension de programmation doit être produite à l'intérieur du circuit intégré lui-même, à partir de sa tension d'alimentation générale. On sait, à partir d'une faible tension d'alimentation générale, par exemple de 5 volts, produire des hautes tensions internes, par exemple de l'ordre de 20 volts.

L'évolution des technologies amène cependant à préconiser des alimentations générales de valeurs plus basses par exemple 3 Volts, voire 1,8 Volts. L'intérêt de ces solutions très basse tension est que l'énergie globale dissipée dans un circuit intégré est réduite, sa température est donc plus basse, et il fonctionne d'autant mieux. En outre, avec la miniaturisation des circuits, les tensions de claquage ou de changement d'état sont réduites de sorte que l'alimentation basse tension devient une nécessité. Cependant, malgré cette miniaturisation, le recours à des hautes tensions de programmation est toujours nécessaire.

Le principe de la production d'une haute tension à l'intérieur d'un circuit intégré consiste à utiliser un circuit élévateur de tension à l'intérieur de ce circuit intégré. Un circuit élévateur de tension comprend par exemple un multiplicateur de type SCHENKEL, ou bien, plus classiquement, une pompe de charge. La technique de réalisation de ces circuits élévateurs est telle que pour une tension d'alimentation donnée, par exemple 5 Volts, la valeur de la haute tension produite est limitée par un maximum, par exemple 20 Volts. Si la tension d'alimentation est plus faible, par exemple 3 Volts, on ne parvient plus à produire que des différences de potentiels de 18 Volts, par exemple en produisant des tensions positives et des tensions négatives dans le circuit. On comprend que, en vertu de cette évolution technologique, il devient de plus en plus difficile de générer des tensions de programmation ou d'effacement de valeur suffisamment élevée pour pouvoir remplir leur fonction. A fortiori si la tension d'alimentation est inférieure à 3 Volts.

En outre, la sortance de l'élévateur de tension, notamment quand c'est une pompe de charge, est d'autant plus faible que la haute tension produite est élevée par rapport à la tension d'alimentation générale de départ.

On sait que la sortance de l'élévateur, entre autre, détermine les performances du circuit en terme du nombre de cellules mémoires que l'on peut programmer ou effacer en même temps, et en terme de rapidité.

Il faut donc réaliser un compromis entre, d'une part, la valeur de la haute tension délivrée par le circuit élévateur, et, d'autre part, la sortance dudit circuit.

Quoi qu'il en soit, toute chute de tension concédée entre la sortie du circuit élévateur et l'entrée de programmation ou d'effacement du plan mémoire est à l'origine d'une limitation des performances du circuit. En effet, pour maintenir une valeur suffisante de la haute tension de programmation ou d'effacement, il faudra compenser cette chute de tension par une tension d'autant plus élevée en sortie du circuit élévateur, ce qui, en conséquence, en réduira la sortance.

Par ailleurs, lors du transfert d'électrons entre la grille flottante 102 et la région drain 104 de la cellule mémoire, il est indispensable que la variation du champ électrique créé entre ces deux zones ne soit pas trop brutale afin de ne pas fragiliser voire détériorer la couche d'oxyde 105.

Par conséquent, on emploie généralement un circuit de génération d'une haute tension en rampe permettant d'augmenter de façon linéaire la tension appliquée sur la grille 101 de commande (programmation) ou sur la région drain 104 (effacement) de la cellule mémoire. La pente de la rampe doit être maintenue inférieure à une valeur critique au dessus de laquelle la couche d'oxyde des transistors à grille flottante serait endommagée.

Le but de la présente invention est de proposer un circuit de génération d'une haute tension en rampe dont la pente soit bien maîtrisée et la valeur maximum (en fin de rampe) suffisamment élevée, tout en présentant de bonnes performances.

On peut de prime abord penser à faire varier linéairement et de façon croissante la tension délivrée par le circuit élévateur lui-même, par exemple en dérivant vers la masse une quantité importante mais décroissante du courant de sortie de la pompe de charge: de cette manière, on empêche la tension en sortie du circuit élévateur d'atteindre trop rapidement sa valeur nominale (qui détermine la valeur maximum de la rampe) et on peut ainsi maîtriser l'élévation de la tension en sortie du circuit élévateur afin de maintenir la pente de cette tension en dessous de la valeur critique. La sortie du circuit élévateur peut alors être connectée directement à l'entrée de programmation ou d'effacement du plan mémoire, en sorte qu'aucune chute de tension ne sera introduite entre ces deux points de circuit. La tension maximale en fin de rampe peut atteindre la valeur nominale de la haute tension délivrée par le circuit élévateur. Une telle solution présente néanmoins un double inconvénient. D'une part, la pompe de charge du circuit élévateur débite un fort courant jusqu'à l'établissement de sa tension nominale de sortie car elle présente alors une très faible impédance. Et forcer sa sortie à rester en dessous de cette tension nominale nécessite donc la dérivation d'un fort courant vers la masse, et ceci en pure perte. Cela est particulièrement dommageable dans les applications où l'alimentation générale est fournie par une source d'alimentation à charge limitée, telle qu'une pile ou une batterie. D'autre part, le fonctionnement de la pompe de charge lors de l'établissement de sa tension nominale de sortie est générateur de perturbations, notamment de nature électromagnétique, susceptibles de nuire au bon fonctionnement de la mémoire. Une telle solution n'est donc pas satisfaisante.

Le document intitulé "Configurable EEPROMS for ASICS" Proceedings of the Custom Integrated Circuits Conference, rédigé par Carney B et Al., publié mai 1988 par l'Institute of Electrical and Electronic Engineers, décrit un circuit de génération d'une rampe de haute tension pour une mémoire EEPROM. Ce circuit génère une haute tension appliquée pendant un cycle de programmation de la mémoire. Une tension d'une pompe de charge est appliquée sur la source d'un transistor P7, dont le drain est relié à la charge destinée à recevoir la rampe de tension. Un condensateur relié au drain, d'une capacité de 27 pF, est traversé par un courant maximal de 0,12 μA. Lorsque le courant traversant le transistor P7 dépasse 0,12 μA, le courant en excès est évacué vers la masse par l'intermédiaire de deux transistors N. La pente de la rampe de tension appliquée sur la mémoire est maintenue à 4,5 V/ms lorsque l'intensité traversant le condensateur vaut 0,12 μA.

On préfère donc, selon l'invention concevoir un circuit de génération d'une haute tension en rampe du type dans lequel la haute tension en rampe est générée à partir d'une haute tension continue de valeur constante délivrée par un circuit élévateur. La haute tension en rampe est disponible en sortie de ce circuit de génération (et non directement en sortie du circuit élévateur) qui est reliée au lieu d'application de la rampe de tension (i.e. à l'entrée de programmation ou d'effacement du plan mémoire).

On connaît de tels circuits dans lesquels un transistor de type N est connecté par son drain en sortie d'un circuit élévateur délivrant une haute tension continue de valeur constante, et par sa source à la charge constituée par l'entrée de programmation ou d'effacement du plan mémoire. Sur la grille de ce transistor de type N, on applique une tension croissant régulièrement avec le temps de manière à contrôler la tension disponible sur la source. Il apparaît alors que cette tension disponible sur la source suit, à une chute de tension VTN intrinsèque près, la valeur de la tension appliquée sur la grille de commande de ce transistor de type N. La charge, connectée à la source du transistor de type N, est donc alimentée en tension.

Dans l'art antérieur, un tel transistor de type N connecté en transistor de charge est toujours utilisé lorsque, comme c'est le cas en l'espèce un fort courant de charge est susceptible d'être débité dans la charge. En effet, toutes choses étant égales par ailleurs, le courant drain d'un transistor de type N est plus élevé que celui d'un transistor de type P (du fait d'une plus grande mobilité des porteurs de charge).

Cependant, la chute de tension intrinsèque occasionnée dans le transistor de type N est généralement de 2 Volts. Ceci amène à ne pouvoir disposer que d'une tension maximale en fin de rampe de 16 Volts avec une haute tension continue constante délivrée par le circuit élévateur de tension égale à 18 volts. Si on veut une tension supérieure à 16 Volts, il faut augmenter la valeur de la haute tension délivrée par le circuit élévateur au détriment de la sortance de la pompe de charge, ainsi qu'il a été dit ci-dessus.

C'est pourquoi, selon l'invention on se propose de remédier à ce problème en agissant complètement différemment. En effet, au lieu de contrôler la tension disponible à la source d'un transistor de type N, on va commander le débit du courant passant au travers d'un transistor de charge de type P connecté par sa source en sortie de l'élévateur de tension et par son drain à la charge. La charge, connectée au drain du transistor de type P est donc alimentée en courant.

Dans l'application de l'invention à la génération d'une haute tension de programmation ou d'effacement d'une mémoire, la charge capacitive est constituée uniquement par l'ensemble des connections, les lignes de bits ou lignes de mots, du plan mémoire de la mémoire.

En supposant constante la valeur de la charge capacitive, il suffit de maintenir un débit de courant constant à travers le transistor de charge de type P pour que la tension sur son drain soit une tension en rampe linéaire croissante de pente constante déterminée par le rapport entre le courant de charge et la valeur (constante) de la charge capacitive. Pour une opération de programmation ou d'effacement déterminée, la valeur de la charge capacitive peut effectivement être tenue pour constante au cours de l'opération. Néanmoins, celle-ci ne peut en réalité être tenue pour constante d'une opération à l'autre. En effet, s'agissant par exemple d'une opération de programmation de rafraîchissement, elle dépendra de l'état initial de la cellule mémoire à programmer. S'agissant d'une opération d'effacement, elle dépendra du nombre de cellules mémoire à effacer (on peut en effet effacer une unique cellule, un groupe de cellules ou la totalité des cellules du plan mémoire).

Selon l'invention, on prévoit un circuit bouclé de commande du courant circulant à travers le transistor de charge de type P qui réalise un asservissement du courant de charge et donc, la charge étant de nature capacitive, de la pente de la haute tension en rampe disponible sur le drain de ce transistor.

Afin de pallier l'ensemble des inconvénients de l'état de la technique précités, l'invention concerne en effet un circuit de génération d'une haute tension en rampe pour l'alimentation en tension d'une charge capacitive notamment une haute tension de programmation ou d'effacement d'au moins une cellule mémoire d'une mémoire non volatile comportant des transistors à grille flottante comme éléments de mémorisation,
ce circuit de génération comprenant :

- un circuit élévateur de tension dont la sortie délivre une haute tension continue de valeur constante;
- un transistor de charge de type P, relié par sa source à la sortie de l'élévateur de tension, par sa grille de commande à un circuit bouclé de commande du courant de charge, et par son drain à la charge, la haute tension en rampe étant disponible sur ce drain,

le circuit bouclé de commande du courant de charge comprenant:

- un moyen de conversion de la valeur de la pente de la haute tension en rampe en une valeur de courant de mesure ;
- des moyens de mesure de l'écart entre le courant de mesure et un courant de référence de valeur déterminée constante ;
- et des moyens de commande du courant de charge circulant à travers le transistor de charge en fonction dudit écart.

Ainsi, le circuit élévateur fonctionne de manière indépendante et n'est donc pas perturbé par le reste du circuit de génération.

En outre, la tension source/drain d'un transistor de type P étant quasiment nulle, la valeur maximum de la haute tension en fin de rampe est sensiblement égale à la haute tension continue de valeur constante délivrée par le circuit élévateur. Ce dernier présente donc une sortance raisonnable eu égards aux besoins et le circuit de génération présente de bonnes performances.

Enfin, le circuit selon l'invention réalise un asservissement de la pente de la haute tension en rampe qui est la tension de commande de la charge. Ainsi, quelle que soit la valeur de la charge capacitive, la pente de la haute tension en rampe disponible sur le drain du transistor de type P est parfaitement maîtrisée. Plus précisément, la charge capacitive étant préférentiellement constituée par un plan mémoire d'une mémoire à programmer ou à effacer, l'asservissement permet de maintenir la pente de la haute tension de programmation ou d'effacement en dessous d'une valeur critique, évitant la détérioration de la mince couche d'oxyde des transistors à grille flottante.

D'autres caractéristiques et avantages de la présente invention apparaîtront encore à la lecture de la description qui va suivre. Celle-ci est purement illustrative et doit être lue en regard des dessins annexés sur lesquels on a représenté:

- à la figure 1 déjà analysée: une vue schématique d'un transistor à grille flottante constituant un élément de mémorisation d'une mémoire;
- à la figure 2: un schéma de principe du circuit selon l'invention;
- à la figure 3: un schéma détaillé d'un mode de réalisation possible du circuit selon l'invention;
- aux figures 4a à 4e: des chronogrammes de signaux et tensions du circuit de la figure 3.

Par convention, aux figures, les transistors en technologie MOS (Metal Oxide Semiconductor) de type P se distinguent des transistors MOS de type N en ce qu'ils comportent un petit rond sur leur grille de commande.

A la figure 2, le circuit élévateur de tension 1 délivre sur sa sortie 4 une haute tension HIV continue de valeur constante, à partir d'une tension d'alimentation générale Vcc. La tension d'alimentation générale a par exemple pour valeur 3 volts. La haute tension continue a par exemple pour valeur 18 volts. Le circuit élévateur de tension 1 comprend préférentiellement une pompe de charge. Afin que la haute tension HIV délivrée par le circuit élévateur soit sensiblement indépendante du courant débité en sortie, celui-ci comprend également un circuit de régulation qui détermine la valeur nominale de la tension HIV, ainsi qu'il est bien connu de l'homme du métier.

Selon l'invention, la sortie 4 du circuit élévateur 1 est portée sur la source d'un transistor de charge 2 de type P. Le drain du transistor de charge 2 constitue donc la sortie S du circuit de l'invention. Le drain de ce transistor est connecté au lieu d'application de la haute tension en rampe. Dans l'application envisagée, il s'agira de l'entrée de programmation ou d'effacement d'une mémoire non-volatile programmable électriquement (mémoire EPROM, EEPROM, mémoire Flash). La charge constituée par le plan mémoire à programmer ou à effacer est de nature capacitive. A la figure 2, cette charge est donc symbolisée par un condensateur 5 représenté en pointillés, et connecté entre la sortie S du circuit et la masse. Cette charge est alimentée en courant mais, s'agissant d'une charge capacitive, c'est indirectement la valeur et la forme de la tension à ses bornes qui est maîtrisée. Le circuit selon l'invention permet en effet d'asservir la tension Vpp en sortie S de manière à ce que cette tension ait la forme d'une rampe croissante dont la pente reste inférieure à une pente critique. Selon un avantage de l'invention, la valeur asymptotique de cette pente, c'est-à-dire la valeur maximum atteinte par la tension Vpp en fin de rampe, est égale à la haute tension HIV délivrée par le circuit élévateur 1. En effet, le transistor de charge 2 présente une tension source/drain pratiquement nulle, de sorte qu'il n'introduit aucune chute de tension entre la sortie du circuit élévateur 1 et la sortie S du circuit de génération de la haute tension en rampe.

Le transistor de charge 2 est traversé par un courant de charge. La tension Vpp aux bornes de la charge capacitive 5 est donc une tension croissante. Sans le circuit bouclé de commande du courant dans le transistor de charge selon l'invention, cette tension atteindrait la tension HIV brutalement. Dit autrement, la pente de la tension Vpp serait très élevée de sorte que la couche d'oxyde des transistors à grille flottante constituant le plan mémoire serait endommagée. C'est pourquoi le circuit bouclé de commande du courant du transistor de charge 2 réalise un asservissement de la pente de la tension en rampe Vpp disponible sur le drain de ce transistor.

A cet effet, ce circuit comprend un moyen de conversion de la valeur de la pente de la haute tension en rampe Vpp en une valeur de courant de mesure Ic. Ce moyen comprend un condensateur de référence Cref, dont une borne est connectée au drain du transistor 2 et dont l'autre borne est connectée sur le drain d'un transistor de type N 7 monté en diode, dont la source est reliée à la masse. La tension drain/source de ce transistor 7 monté en diode étant à peu près constante, la tension aux bornes du condensateur de référence Cref suit la haute tension de rampe Vpp au point S. Lorsque la tension Vpp augmente linéairement (c'est-à-dire avec une pente constante), le transistor Cref se charge avec un courant constant Ic. Ce courant constitue un courant de mesure, proportionnel à la pente de la haute tension en rampe Vpp. Le circuit comprend également des moyens de mesure de l'écart entre ce courant de mesure Ic et un courant de référence Iref de valeur déterminée et constante. Ces moyens de mesure comprennent un amplificateur de différence qui comporte un transistor de type P 8 et un transistor de type N 9 montés en série. La source du transistor de type P 8 est reliée à une borne d'alimentation positive, sur laquelle une tension continue positive et constante est disponible (il s'agira préférentiellement de la tension d'alimentation générale Vcc et non de la haute tension HIV de manière à ne pas pénaliser les performances - en termes de courant de sortie disponible pour la charge - du circuit élévateur 1 dont la sortance est limitée), et son drain est connecté à un noeud A. La grille de commande du transistor 8 reçoit une tension de polarisation IREFP délivrée par un circuit de polarisation 11. Ce circuit de polarisation comprend une source de courant 13 délivrant le courant de référence Iref, en série avec un transistor de type P 12 monté en diode, entre la borne d'alimentation positive Vcc et la masse. La grille de commande et le drain du transistor de type P 12 sont reliés à la grille de commande du transistor 8 pour lui transmettre la tension de polarisation IREFP. De cette manière, les transistors de type P 8 et 12 fonctionnent en miroir de courant, de sorte que le courant circulant entre la borne d'alimentation positive et le noeud A à travers le transistor 8 soit proportionnel au courant de référence Iref généré par la source de courant 13. On sait que le coefficient de proportionnalité dépend du rapport des tailles des transistors 8 et 12 constituant le miroir de courant, et est déterminé par la largeur de grille de ces transistors. Dans un mode de réalisation possible, représenté aux figures, ce coefficient est égal à l'unité, les transistors 8 et 12 étant de même taille.

L'amplificateur de différence comporte en outre le transistor de type N 9 dont le drain est relié au noeud A et la source à la masse. La grille de commande du transistor 9 est relié à la grille de commande et au drain du transistor 7 monté en diode de sorte que ces transistors fonctionnent en miroir de courant. De cette manière, le courant circulant entre le noeud A et la masse à travers le transistor 9 est proportionnel au courant de mesure Ic circulant à travers le condensateur de référence Cref. De la même façon que ce qui a été exposé pour le miroir du courant constitué par les transistors 8 et 12, on considère à la figure 2 que le coefficient de proportionnalité entre ces courants est égal à l'unité, les transistor 7 et 9 étant de même taille, de sorte que le courant traversant le transistor 9 est égal au courant de mesure Ic. On verra ultérieurement comment on peut modifier ces coefficients et l'effet technique que cela procure.

La tension au noeud A, constituant le noeud de sortie des moyens de comparaison selon l'invention, est fonction de l'écart entre le courant de référence Iref et le courant de mesure Ic.

Les transistors 8 et 9 fonctionnent en amplificateur de cette différence.

Le circuit de génération selon l'invention comporte enfin des moyens de commande du courant de charge circulant à travers le transistor de charge 2, en fonction de l'écart entre le courant de référence Iref et le courant de mesure Ic. Ces moyens comprennent à cet effet un transistor de type N 10 dont la source est reliée à la masse, dont la grille de commande est reliée au noeud A de sortie des moyens de mesure de l'écart entre Iref et Ic, et dont le drain est connecté au drain et à la source d'un transistor de type P 3 monté en diode dont la source est en outre reliée à la sortie du circuit élévateur 1 délivrant la haute tension HIV. La grille de commande et le drain du transistor 3 sont reliés à la grille de commande du transistor de charge 2, de sorte que ces deux transistors fonctionnent en miroir de courant. Le courant de charge circulant à travers le transistor de charge 2 est donc proportionnel au courant circulant à travers le transistor 10, celui-ci étant commandé par la tension au noeud de sortie A des moyens de mesure de l'écart entre Iref et Ic.

Le circuit bouclé fonctionne de manière à annuler la différence entre les courants circulant entre la borne d'alimentation positive et le noeud A à travers le transistor 8 d'une part, et le courant circulant entre le noeud A et la masse à travers le transistor 9 d'autre part.

Le principe de fonctionnement du circuit de la figure 2 est la suivant. Si la charge 5 connectée en sortie S du circuit de génération d'une haute tension en rampe selon l'invention appelle un fort courant de charge (de valeur constante pour une opération de programmation ou d'effacement déterminée) la tension Vpp aux bornes de la charge 5, qui est la tension Vpp sur le drain du transistor de charge 2, croît linéairement avec une pente constante. Cette pente est convertie en un courant de mesure Ic par le condensateur Cref selon la formule

$$Ic = Cref \times \frac{dVpp}{dt}$$

Ce courant Ic est un courant constant si la charge capacitive 5 est elle-même constante. Ce courant de mesure Ic est comparé au courant de référence Iref par l'amplificateur de différence constitué par les transistors 8 et 9. Si le courant de mesure Ic est supérieur (respectivement inférieur) au courant de référence Iref, c'est-à-dire si la pente de la tension Vpp est supérieure (respectivement inférieure) à une pente critique déterminée par la valeur du courant Iref, la tension au noeud A diminue (respectivement augmente). Il résulte que la tension grille/source du transistor de type N 10 diminue (respectivement augmente) et que le courant qui le traverse diminue (respectivement augmente) en conséquence. Ainsi, le courant de charge circulant à travers le transistor de charge 2, est également diminué (respectivement augmenté), de sorte que la pente de la tension en rampe Vpp sur son drain diminue (respectivement augmente). Comme on l'aura compris, le circuit bouclé de commande en courant du transistor de charge 2 fonctionne de manière à annuler la différence entre le courant de mesure Ic et le courant de mesure Iref, d'où il résulte que la pente de la tension en rampe Vpp qui est appliquée à la charge 5 est maintenue égale à une valeur critique déterminée par la valeur du courant Iref. En pratique, le circuit bouclé sert essentiellement à maintenir la pente de la tension Vpp en dessous de ladite valeur critique dans la mesure où celle-ci tend naturellement à être trop élevée.

On notera que le transistor 10 fonctionne en saturation, c'est-à-dire que son courant de drain est déterminé par la tension VGS entre sa grille et sa source.

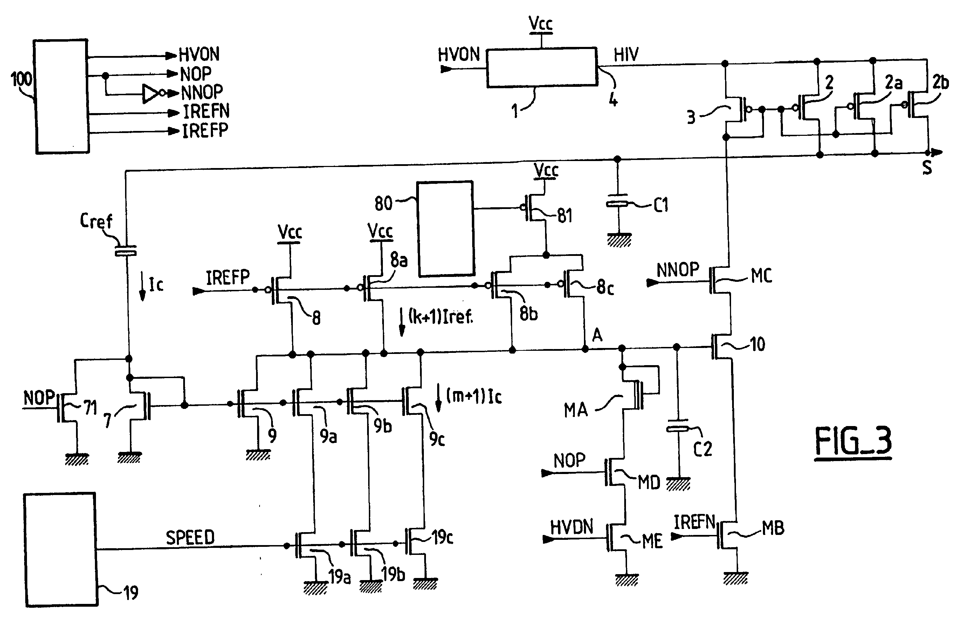

A la figure 3 on a représenté un mode de réalisation possible d'un circuit de génération d'une haute tension en rampe selon l'invention. Sur cette figure, les mêmes éléments qu'à la figure 2 portent les mêmes références, et ne seront pas à nouveau décrits en eux-mêmes. Le schéma de la figure 3 se distingue de celui de la figure 2 par la présence de certains éléments de contrôle et/ou de commande supplémentaires, commandés par des signaux de commande générés par une unité de commande 100. D'autres fonctionnalités du circuit seront expliquées par la présentation de composants supplémentaires.

Le transistor de type N 10 est connecté en série avec le transistor de type P 3 monté en diode, et avec deux autres transistors de type N, respectivement MB et MC. Le transistor MB dont la source est reliée à la masse et dont le drain est relié à la source du transistor 10, reçoit sur sa grille de commande un signal de polarisation IREFN. Le transistor MC dont la source est connectée au drain du transistor 10 et dont le drain est connecté au drain et à la grille de commande du transistor 3, reçoit sur sa grille de commande un signal NNOP. Un transistor de type N 71 est connecté en parallèle sur le transistor 7 monté en diode. Ce transistor 71 est relié par son drain au drain et à la grille de commande du transistor 7, et par sa source à la masse. Il reçoit sur sa grille de commande un signal de commande NOP qui est le complémentaire du signal NNOP précité. Lorsque le signal NOP est à l'état logique 1, le transistor 7 monté en diode est court-cuircuité, de sorte que la régulation est inactive. Lorsqu'il est à l'état logique zéro, la régulation est active.

Deux autres transistors de type P 2a et 2b sont connectés en parallèle sur le transistor de charge 2. Cette disposition est prévue de manière à pouvoir disposer d'un courant de charge suffisant. On notera que la largeur de grille des transistors de charge 2, 2a et 2b est dix fois plus importante que celle du transistor 3 monté en diode. Ainsi, le courant de charge est trente fois supérieur au courant imposé dans la branche comprenant les transistors 3, MC, 10 et MB.

Des transistors de type P respectivement 8a, 8b, 8c sont connectés en parallèle avec le transistor 8. Certains au moins 8b et 8c de ces transistors ont leur source reliée à la borne d'alimentation positive (délivrant la tension Vcc) par l'intermédiaire d'un transistor de type P 81 fonctionnant en interrupteur commandé par un circuit d'activation 80. Ce circuit 80 comprend des moyens non représentés de comparaison de la tension d'alimentation générale Vcc à un seuil, et génère un signal logique porté sur la grille de commande du transistor 81 pour le rendre passant lorsque la tension Vcc est inférieure à ce seuil. Dans un mode de réalisation préféré, le seuil est égal à 2,2 volts. Le courant circulant entre la borne d'alimentation positive Vpp et le noeud A est alors augmenté, de sorte que la haute tension en rampe Vpp ne pourra s'élever qu'avec une pente réduite. En effet, lorsque la tension d'alimentation générale Vcc est inférieure au seuil de 2,2 volts, la pompe de charge constituant le circuit élévateur 1 n'est pas capable de fournir un courant de sortie suffisant pour charger le plan mémoire avec une pente aussi importante que lorsque la tension d'alimentation générale Vcc est dans la plage comprise entre 3 et 5 volts, qui constitue une plage de fonctionnement correct pour la pompe de charge. C'est pourquoi il convient de réduire la pente de la haute tension en rampe Vpp. La programmation ou l'effacement se feront moins rapidement mais se feront tout de même. Dans le cas où k transistors 8a, 8b, 8c ... sont connectés en parallèle sur le transistor 8, c'est donc un courant égal à $(k + 1) \times$ Iref qui circule entre la borne d'alimentation positive Vcc et le noeud A.

D'autres transistors de type P 9a, 9b, 9c sont également connectés en parallèle sur le transistor 9. Certains au moins de ces transistors (et à la figure 3 tous ces transistors) sont reliés par leur source à la masse par l'intermédiaire de transistors de type N, respectivement 19a, 19b, 19c, fonctionnant en interrupteur. La source de ces transistors 19a, 19b, 19c est reliée à la masse et leur drain à la source des transistors 9A, 9b, 9c. Sur leur grille de commande, les transistors 19a, 19b, 19c reçoivent un même signal SPEED généré par un circuit d'accélération 19. Lorsque le signal logique SPEED est à l'état logique 1, les interrupteurs 19a, 19b, 19c sont passants. Si ces transistors sont au nombre de m, où m est un entier, c'est donc un courant égal à $(m + 1) \times$ Ic qui circule entre le noeud A et la masse. Le circuit d'accélération 19 comprend des moyens non représentés de comparaison de la haute tension en rampe VPP à un seuil (qui vaut par exemple 10 volts), le signal SPEED étant à l'état logique 1 lorsque la tension Vpp est inférieure à ce seuil et à l'état logique 0 dans le cas contraire. Lorsque le signal SPEED est à l'état logique 1, la haute tension en rampe Vpp présente une pente plus importante. En effet, tant que la valeur de cette tension est inférieure à 10 volts, la couche d'oxyde des transistors à grille flottante constituant le plan mémoire n'est pas détériorée et l'on peut donc charger le plan mémoire plus rapidement, la haute tension Vpp pouvant alors présenter une pente supérieure à la pente critique sans risque d'endommagement de cette couche d'oxyde.

Dans le cas le plus général, la tension au noeud A est donc une fonction f du courant de référence Iref et du courant de mesure Ic qui est une combinaison linéaire de ces courants affectés des coefficients $k + 1$ et $m + 1$ respectivement. La fonction du circuit bouclé de commande du courant de charge est d'annuler l'expression $(k + 1) \times$ Iref $- (m + 1) \times$ Ic. Le circuit comporte en outre un transistor de type N MA monté en diode, dont le drain et la grille de commande sont reliés au noeud A et dont la source est reliée à la masse à travers deux transistors de type N, respectivement MD et ME, montés en série. Le transistor MD dont le drain est reliée à la source du transistor MA et la source est reliée au drain du transistor ME, reçoit sur son entrée de commande le signal logique NOP précité. Le transistor ME, dont la source est reliée à la masse, reçoit sur sa grille de commande un signal logique HVON. Un condensateur C2 est par ailleurs connecté entre le noeud A et la masse. Le rôle de ces composants sera expliqué ci-dessous.

En outre, un condensateur C1 est connecté entre la sortie S du circuit et la masse afin de limiter le gain de la boucle de rétroaction pour les faibles valeurs de la charge (par exemple pour une opération de programmation d'un unique bit de la mémoire).

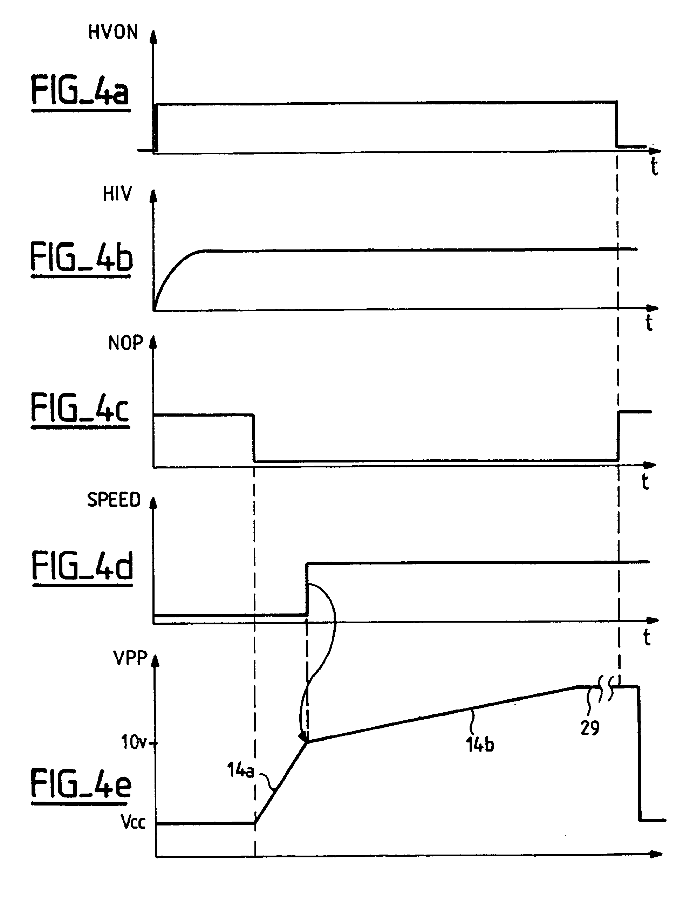

Le fonctionnement du circuit de la figure 3 va maintenant être décrit en regard des chronogrammes des figures 4a à 4e. A l'origine, le signal NOP est à l'état logique 1 et le signal HVON est à l'état logique 0.

La tension Vpp a initialement la même valeur que la tension d'alimentation générale Vcc.

Lorsque le signal HVON passe à l'état logique 1, la pompe de charge constituant le circuit élévateur 1 commence à fonctionner; la tension HIV délivrée par sa sortie 4 croît alors jusqu'à atteindre sa valeur nominale de sortie (figure 4b) qui, dans un exemple, est de 18 volts, la valeur de la tension d'alimentation générale Vcc étant de 3 volts.

En outre, le transistor ME devient alors passant. Comme le transistor MD est initialement passant du fait que le signal NOP est initialement à l'état logique 1, un courant peut circuler depuis la borne d'alimentation positive Vcc à travers les transistors 8 et 8a (et, le cas échéant, également à travers les autres transistors 8b et 8c connectés en parallèle), et à travers le transistor MA monté en diode et les transistors MD et ME. La tension au noeud A s'élève alors pour atteindre une valeur sensiblement égale à un volt (1 v) et la condensateur C2 se charge à cette valeur.

On notera qu'aucun courant ne circule dans la branche contenant le transistor 10 dans la mesure où le transistor MC est bloqué par le signal NNOP à l'état logique 0. En outre, le transistor 71 est rendu passant par le signal NOP à l'état logique 1 en sorte que la rétroaction n'est pas active (le courant Ic s'écoule entièrement vers la masse à travers le transistor 71).

Au bout d'un temps suffisamment long pour que la haute tension HIV ait atteint sa valeur nominale (elle restera alors constante, aux petites chutes de tension dues à d'éventuels pics de courant débité dans la charge près), le signal NOP passe de l'état logique 1 à l'état logique 0 (figure 4c). Le transistor 71 devient alors bloqué. La rétroaction devient active dans la mesure où le courant Ic s'écoule désormais à travers le transistor 7 monté en diode.

De même, le transistor MD se bloque en sorte que la branche contenant le transistor MA n'est plus parcourue par du courant.

Inversement, le transistor MC est rendu passant par le signal NNOP (qui est le complémentaire du signal NOP) à l'état logique 1.

Le circuit peut alors fonctionner selon le principe expliqué ci-dessus en regard de la figure 2. La haute tension Vpp monte alors linéairement avec une perte

$$\frac{dVpp}{dt}$$ limitée à une valeur seuil quelque soit la valeur de la charge, un courant de charge étant alors délivré sur les drains des transistors de charge 2, 2a et 2b, qui constituent la sortie S du circuit, pour charger le plan mémoire.

Tant que la haute tension Vpp est inférieure au seuil du circuit d'accélération 19 (qui est égal à 10 volts), le signal SPEED est à l'état logique 0 (figure 4d). Les interrupteurs 19a, 19b et 19c sont bloqués et seul le transistor 9 est traversé par un courant Ic. La pente de la tension Vpp est alors importante à l'origine comme on le voit sur la figure 4e sur laquelle cette pente est référencée 14a. Ceci permet une charge plus rapide du plan mémoire pour les valeurs de Vpp pour lesquelles la couche d'oxyde 105 des transistors à grille flottante qui le constituent ne risque pas d'être endommagée.

Par contre, dès lors que la haute tension Vpp devient supérieure au seuil du circuit d'accélération 19, le signal SPEED passe à l'état logique 1 (figure 4d). Les k transistors montés en parallèle sur le transistor de type P 9 (ici les trois transistors 9a, 9b, 9c) sont passants et débitent chacun un courant égal au courant de mesure Ic depuis le noeud A vers la masse à travers les interrupteurs respectivement 19a, 19b et 19c. C'est donc au total un courant égal à k + 1 fois (ici quatre fois) le courant de mesure Ic qui circule du noeud A vers la masse. La haute tension Vpp s'élève donc avec une pente moins importante, référencée 14b à la figure 4e, et en tout état de cause inférieure à la perte critique. En effet, la tension au noeud A est alors "tirée" vers la masse par quatre transistors au lieu d'un seul.

Ainsi qu'on l'aura compris, plus le coefficient de proportionnalité entre le courant circulant du noeud A vers la masse d'une part et le courant de mesure Ic d'autre part est important, et plus la tension au noeud A est faible, en sorte que le courant de charge est faible et que (pour une charge de valeur constante pendant une opération de programmation ou d'effacement déterminée), la pente de la haute tension en rampe Vpp est faible.

A l'inverse, plus le coefficient de proportionnalité entre le courant circulant entre la borne d'alimentation positive Vcc et le noeud A d'une part et le courant de référence Iref d'autre part est élevé, et plus la tension au noeud A est élevée, en sorte que le courant de charge est élevé et la pente de la haute tension en rampe Vpp (toujours pour une charge capacitive de valeur constante) est grande.

Lorsque la haute tension en rampe Vpp atteint la valeur maximum de la rampe, qui (grâce au fait que le transistor de charge 2 soit un transistor de type P) est la tension HIV délivrée par le circuit élévateur, la pente de la tension Vpp devient nulle (figure 4e). Le circuit selon l'invention cherche néanmoins à la maintenir autour de la valeur critique. Il est donc à craindre que le courant de charge soit augmenté de façon importante et devienne impossible à fournir par la sortie 4 du circuit élévateur 1 sans perturber le niveau de la haute tension continue HIV qu'il délivre. Afin d'empêcher cela, le transistor MB est polarisé par la tension IREFN de telle manière à ce qu'il limite le courant circulant dans la branche comprenant les transistors 3, MC, 10 et MB. Ainsi, le courant de charge peut être limité à quelques micro-ampères (mA).

Le fonctionnement du circuit de l'invention est interrompu lorsque le signal NOP repasse à l'état logique 1. Le signal HVON passe alors à l'état logique O pour interrompre la consommation de courant entre le noeud A et la masse à travers le transistor MA.

On notera enfin que le condensateur C2 a également un rôle dynamique et limite le gain de la boucle de régulation pour les hautes fréquences.

**Revendications**

1. Circuit de génération d'une haute tension en rampe pour l'alimentation en tension d'une charge capacitive, notamment une haute tension de programmation ou d'effacement d'au moins une cellule mémoire d'une mémoire non volatile comportant des transistors à grille flottante comme éléments de mémorisation, le circuit comprenant

   - un circuit élévateur de tension (1) dont la sortie délivre une haute tension (HIV) continue de valeur constante ;
   - un transistor de charge de type P (2), relié par sa source à la sortie de l'élévateur de tension (1), et par son drain à la charge (5), la haute tension en rampe (Vpp) étant disponible sur ce drain (S),

   **caractérisé en ce que** la grille de commande du transistor de charge est reliée à un circuit bouclé de commande du courant de charge et **en ce que** le circuit bouclé de commande du courant de charge comprend:

- un moyen de conversion (Cref) de la valeur de la pente de la haute tension en rampe (Vpp) en une valeur de courant de mesure (Ic) ;
- des moyens de mesure de l'écart entre le courant de mesure (Ic) et un courant de référence (Iref) de valeur déterminée constante ;
- et des moyens de commande du courant de charge circulant à travers le transistor de charge (2) en fonction dudit écart.

2. Circuit selon la revendication 1, **caractérisé en ce que** le moyen de conversion (Cref) est un condensateur de référence de valeur déterminée constante.

3. Circuit selon la revendication 1 ou la revendication 2, **caractérisé en ce que** les moyens de mesure de l'écart entre le courant de mesure (Ic) et le courant de référence (Iref) comprennent un amplificateur de différence comportant :

- au moins un premier transistor de type P (8) relié par sa source à une borne d'alimentation positive (Vcc), par son drain à un noeud de sortie (A), et recevant sur sa grille de commande une tension de polarisation (IREFP) telle que le courant circulant entre la borne d'alimentation positive (Vcc) et le noeud de sortie (A) soit proportionnel au courant de référence (Iref) ;
- au moins un premier transistor de type N (9) relié par sa source à la masse, par son drain au noeud de sortie (A) et recevant sur sa grille de commande une tension de polarisation telle que le courant circulant entre le noeud de sortie (A) et la masse soit proportionnel au courant de mesure (Ic).

4. Circuit selon la revendication 3, **caractérisé en ce que** les moyens de mesure de l'écart entre le courant de mesure (Ic) et le courant de référence (Iref) comprennent k autres transistors de type P (8a,8b,8c) connectés en parallèle sur le premier transistor de type P (8), où k est un nombre entier, la source de certains au moins de ces k autres transistors étant reliée à la borne d'alimentation positive (Vcc) par l'intermédiaire d'un interrupteur (81) dont l'état passant est commandé par un circuit d'activation (80) lorsque la valeur de ladite tension d'alimentation est inférieure à un seuil déterminé afin d'augmenter le coefficient de proportionnalité entre le courant circulant de la borne d'alimentation positive (Vcc) vers le noeud de sortie (A) d'une part, et le courant de référence (Iref) d'autre part.

5. Circuit selon la revendication 3 ou selon la revendication 4, **caractérisé en ce que** les moyens de mesure de l'écart entre le courant de mesure (Ic) et le courant de référence (Iref) comprennent m autres transistors de type N (9a,9b,9c) connectés en parallèle sur ledit premier transistor de type N (9), où m est un nombre entier, la source de certains au moins de ces m autres transistors étant reliée à la masse par l'intermédiaire respectivement de m interrupteurs (19a,19b,19c) dont l'état passant est commandé par un circuit d'accélération (19) lorsque la valeur de la haute tension en rampe (Vpp) est supérieure à un seuil déterminé afin d'augmenter le coefficient de proportionnalité entre le courant circulant du noeud de sortie (A) vers la masse d'une part, et le courant de mesure (Ic) d'autre part.

6. Circuit selon la revendication 2 et la revendication 3, **caractérisé en ce qu'**une première borne du condensateur de référence est connectée au drain du transistor de charge (2) et **en ce que** sa seconde borne est connectée au drain d'un transistor (7) de type N monté en diode dont la source est connectée à la masse et dont la grille de commande est connectée à la grille de commande du transistor de type N (9) de l'amplificateur de différence pour lui transmettre sa tension de polarisation, en sorte que les deux transistors fonctionnent en miroir de courant.

7. Circuit selon la revendication 3, **caractérisé en ce que** les moyens de commande du courant de charge circulant à travers le transistor de charge (2) comprennent un transistor de type N (10) dont la grille de commande est reliée au noeud de sortie (A) des moyens de mesure de l'écart entre le courant de mesure (Ic) et le courant de référence (Iref), dont la source est reliée à la masse et dont le drain est connecté à un transistor de type P monté en diode et relié par sa source à la haute tension d'alimentation continue (HIV) et par son drain et sa grille de commande à la grille de commande du transistor de charge (2), en sorte que ces transistors fonctionnent en miroir de courant.

**Claims**

1. A generation circuit for generating a ramp high voltage for the supply of voltage to a capacitive load, in particular a high voltage for programming or erasing at least one storage cell of a non volatile storage comprising floating-gate transistors as storage elements, said generation circuit comprising:

- a voltage booster circuit (1) the output of which provides a high direct voltage (HIV) of constant value;
- a P type load transistor (2) connected by its source to the output of the voltage booster circuit (1), and by its drain to the capacitive load (5), the ramp high voltage (Vpp) being available at the drain (5), **characterised in that** the load transistor control gate is coupled to a control feedback circuit to control the load current, and **in that** the control feedback circuit to control the load current includes:

■ converting means (Cref) for converting the value of the slope of the ramp high voltage (Vpp) into a value of a measurement current (Ic);
■ means for measuring the difference between the measurement current (Ic) and a reference current (Iref) having a constant specified value; and
■ means for controlling the load current flowing through the P type load transistor (2) as a function of said difference.

2. The circuit of claim 1, **characterised in that** the converting means (Cref) comprises a reference capacitor with a constant specified value.

3. The circuit of claim 1 or 2, **characterised in that** the means for measuring the difference between the measurement current (Ic) and the reference current (Iref) include a difference amplifier comprising:

- at least one first P type transistor (8) connected by its source to a positive supply voltage terminal (Vcc) and by its drain to an output node (A), and receiving a bias voltage (IREFP) at its control gate such that the current flowing between the positive supply terminal (Vcc) and the output node (A) is proportional to the reference current (Iref);
- at least one first N type transistor (9) connected by its source to the ground and by its drain to the output node (A), and receiving a bias voltage at its control gate such that the current flowing between the output node (A) and the ground is proportional to the measurement current (Ic).

4. The circuit of claim 3, **characterised in that** the means for measuring the difference between the measurement current (Ic) and the reference current (Iref) include k other P type transistors (8a, 8b, 8c) parallel-connected to the first P type transistor (8), where k is an integer, the sources of at least some of the k other transistors being connected to the positive supply terminal (Vcc) through a switch (81) whose ON state is activated by an activation circuit (80) when the value of said supply voltage is below a specified threshold in order to increase the coefficient of proportionality between, firstly, the current flowing from the positive supply terminal (Vcc) to the output node (A) and, secondly, the reference current (Iref).

5. The circuit of claim 3 or 4, **characterised in that** the means for measuring the difference between the measurement current (Ic) and the reference current (Iref) include m other N type transistors (9a, 9b, 9c) parallel-connected to said first N type transistor (9), where m is an integer, the sources of at least some of these m other transistors being connected to the ground through m switches respectively, whose ON state is activated by an acceleration circuit (19) when the value of the ramp high voltage (Vpp) is above a specified threshold in order to increase the coefficient of proportionality (A) between, firstly, the current flowing from the output node (A) to the ground and, secondly, the measurement current (Ic).

6. The circuit of claims 2 and 3, **characterised in that** a first terminal of the reference capacitor is connected to the drain of the load transistor (2) and **in that** its second terminal is connected to the drain of a diode-mounted N type transistor (7) whose source is connected to the ground and whose control gate is connected to the control gate of the N type transistor (9) of the difference amplifier to transmit its bias voltage to it so that the two transistors work as a current mirror.

7. The circuit of claim 3, **characterised in that** the means to control the load current flowing through the load transistor (2) comprise an N type transistor (10) having its control gate connected to the output node (A) of the means to measure the difference between the measurement current (Ic) and the reference current (Iref), its source connected to the ground and its drain connected to a diode-mounted P type transistor that is connected by its source to the high direct supply voltage (HIV) and by its drain and its control gate to the control gate of the load transistor (2), so that these transistors work as a current mirror.

**Patentansprüche**

1. Schaltung zur Erzeugung einer ansteigenden Hochspannung für die Spannungsversorgung einer kapazitiven Last, insbesondere einer Hochspannung zum Programmieren oder Löschen mindestens einer Speicherzelle eines nicht-flüchtigen Speichers, der Floating-Gate-Transistoren als Speicherelemente aufweist, wobei die Schaltung umfasst:

- eine Spannungsanhebeschaltung (1), deren Ausgang eine Gleichhochspannung (HIV) konstanten Betrages ausgibt,
- einen Lasttransistor vom P-Typ (2), der über seine Source an den Ausgang des Spannungsanhebers (1) angeschlossen ist und über seinen Drain an die Last (5), wobei die ansteigende Hochspannung (Vpp) an diesem Drain (S) zur Verfügung steht,

**dadurch gekennzeichnet, dass** das Steuergitter des Lasttransistors mit einer Schleifenschaltung zur Steuerung des Laststromes verbunden ist und dadurch, dass die Schleifenschaltung zur Steuerung des Laststromes umfasst:

- ein Mittel zur Umsetzung (Cref) des Wertes der Steigung der ansteigenden Hochspannung (Vpp) in einen Strommesswert (Ic).
- Mittel zur Messung der Abweichung des Messstroms (Ic) von einem Bezugsstrom (Iref) eines festgelegten konstanten Wertes,
- und Mittel zur Steuerung des Laststromes, der den Lasttransistor (2) durchfließt, in Abhängigkeit von der genannten Abweichung.

2. Schaltung nach Patentanspruch 1, **dadurch gekennzeichnet, dass** das Umsetzungsmittel (Cref) ein Bezugskondensator eines festgelegten konstanten Wertes ist.

3. Schaltung nach Patentanspruch 1 oder Patentanspruch 2, **dadurch gekennzeichnet, dass** die Mittel zur Messung der Abweichung des Messstroms (1c) vom Bezugsstrom (Iref) einen Differenzverstärker aufweisen, umfassend:

- mindestens einen ersten P-Transistor (8), der über seine Source mit einem positiven Versorgungsanschluss (Vcc) verbunden ist, über seinen Drain mit einem Ausgangsknoten (A), und der an seinem Steuergitter eine Polarisationsspannung (IREFP) empfängt, derart, dass der Strom, der zwischen dem positiven Versorgungsanschluss (Vcc) und dem Ausgangsknoten (A) fließt, zum Bezugsstrom (Iref) proportional ist,
- mindestens einen ersten N-Transistor (9), der über seine Source mit der Masse verbunden ist, über seinen Drain mit dem Ausgangsknoten (A) und der an seinem Steuergitter eine Polarisationsspannung empfängt, derart, dass der Strom, der zwischen dem Ausgangsknoten (A) und der Masse fließt, zum Messstrom (Ic) proportional ist.

4. Schaltung nach Patentanspruch 3, **dadurch gekennzeichnet, dass** die Mittel zur Messung der Abweichung des Messstroms (Ic) vom Bezugsstrom (Iref) k weitere P-Transistoren (8a, 8b, 8c) umfassen, die zum ersten P-Tansistor (8) parallel geschaltet sind, wobei k eine ganze Zahl ist, wobei die Source mindestens bestimmter dieser k weiteren Transistoren mit dem positiven Versorgungsanschluss (Vcc) über einen Schalter (81) verbunden sind, dessen Durchlasszustand von einem Betätigungskreis (80) gesteuert wird, wenn der Wert der genannten Versorgungsspannung unter einem bestimmten Schwellenwert liegt, um den Koeffizienten der Proportionalität des Stromes, der von der positiven Versorgungsklemme (Vcc) zum Ausgangsknoten (A) fließt, einerseits und dem Bezugsstrom (Iref) andererseits zu erhöhen.

5. Schaltung nach Patentanspruch 3 oder nach Patentanspruch 4, **dadurch gekennzeichnet, dass** die Mittel zur Messung der Abweichung des Messstroms (1c) vom Bezugsstrom (Iref) m weitere N-Transistoren (9a, 9b, 9c) umfassen, die zum genannten ersten N-Transistor (9) parallel geschaltet sind, wo m eine ganze Zahl ist, wobei die Source mindestens bestimmter dieser m weiteren Transistoren über m Schalter (19a, 19b, 19c) jeweils mit der Masse verbunden sind, deren Durchlasszustand von einem Beschleunigungskreis (19) geschaltet wird, wenn der Wert der ansteigenden Hochspannung (Vpp) höher ist, als ein bestimmter Schwellenwert, um den Koeffizienten der Proportionalität des Stromes, der vom Ausgangsknoten (A) zur Masse fließt, einerseits und dem Messstrom (Ic) andererseits zu erhöhen.

6. Schaltung nach Patentanspruch 2 und Patentanspruch 3, **dadurch gekennzeichnet, dass** ein erster Anschluss des Bezugskondensators an den Drain des Lasttransistors (2) angeschlossen ist und dadurch, dass sein zweiter Anschluss mit dem Drain eines N-Transistors (7) verbunden ist, der als Diode geschaltet ist und dessen Source mit der Masse verbunden ist und dessen Steuergitter mit dem Steuergitter des N-Transistors (9) des Differenzverstärkers verbunden ist, um an ihn seine Polarisationsspannung zu übertragen, so dass die beiden Transistoren mit Spiegelstrom arbeiten.

7. Schaltung nach Patentanspruch 3, **dadurch gekennzeichnet, dass** die Mittel zur Steuerung des Laststromes, der den Lasttransistor (2) durchfließt, einen N-Transistor (10) umfassen, dessen Steuergitter mit dem Ausgangsknoten (A) der Mittel zur Messung der Abweichung des Messstroms (Ic) vom Bezugsstrom (Iref) verbunden ist, dessen Source mit der Masse verbunden ist und dessen Drain mit einem P-Transistor verbunden ist, der als Diode geschaltet ist und über seine Source mit der Versorgungsgleichhochspannung (HIV) verbunden ist und über sein Drain und sein Steuergitter mit dem Steuergitter des Lasttransistors (2), derart dass diese Transistoren mit Spiegelstrom arbeiten.

## FIG_1

## FIG_2

FIG_3

HVON

## FIG_4a

t

HIV

## FIG_4b

t

NOP

## FIG_4c

t

SPEED

## FIG_4d

t

VPP

10v

## FIG_4e

14a

14b

29

Vcc